## Europäisches Patentamt
## European Patent Office
## Office européen des brevets

(19)

(11) Veröffentlichungsnummer: **0 001 042**
**B1**

(12)

# EUROPÄISCHE PATENTSCHRIFT

(45) Veröffentlichungstag der Patentschrift:
12.08.81

(51) Int. Cl.³: **G 03 F 7/20,** H 01 J 37/30,
G 03 F 1/00, H 01 L 21/00

(21) Anmeldenummer: **78100442.9**

(22) Anmeldetag: **19.07.78**

(54) Verfahren und Vorrichtung zur Belichtung durch Korpuskularstrahlen-Schattenwurf.

(30) Priorität: **02.09.77 DE 2739502**

(43) Veröffentlichungstag der Anmeldung:
**21.03.79 Patentblatt 79/6**

(45) Bekanntmachung des Hinweises auf die Patenterteilung:
**12.08.81 Patentblatt 81/32**

(84) Benannte Vertragsstaaten:
**DE FR GB**

(56) Entgegenhaltungen:
**DE-B-2 460 716**
**FR-A-2 106 298**
**FR-A-2 242 754**
**FR-A-2 328 281**
**ELECTROCHEMICAL SOCIETY, Extended Abstracts, Band 74-1; Abstract No. 218, Seite 510—511**
**G. L. VARNELL et al.: »High Speed Electron Beam Pattern Generation«**

(73) Patentinhaber: **International Business Machines Corporation, Armonk, N.Y. 10504 (US)**

(72) Erfinder: **Bohlen, Harald, Dipl.-Phys., Geleener Strasse 26, D-7030 Böblingen (DE)**
Erfinder: **Greschner, Johann, Dr. Dipl.-Phys., Zollernstrasse 14, D-7401 Pliezhausen 2 (DE)**
Erfinder: **Kulcke, Werner, Dr. Dipl.-Phys., Westerwaldweg 8, D-7030 Böblingen (DE)**
Erfinder: **Nehmiz, Peter, Dr. Dipl.-Phys., Adlerstrasse 7, D-7030 Böblingen (DE)**

(74) Vertreter: **Teufel, Fritz, Dipl.-Phys., Schönaicher Strasse 220, D-7030 Böblingen (DE)**

## Verfahren und Vorrichtung zur Belichtung durch Korpuskularstrahlen-Schattenwurf

Die Erfindung betrifft ein Verfahren und eine Vorrichtung zur Belichtung eines Objekts durch Korpuskularstrahlen nach dem Oberbegriff von Anspruch 1 und 3.

Ein derartiges Verfahren ist aus der DE-B-2 460 716 bekannt.

Bei der Herstellung von integrierten Halbleiterschaltungen werden bekanntlich die in jedem Verfahrensschritt zu bearbeitenden Bereiche eines in der Regel Hunderte von einander gleichen Einzelschaltungen enthaltenden Halbleiterplättchens mit Hilfe von mit dem jeweils erforderlichen Muster belichteten und entwickelten Photolackschichten definiert. Mit fortschreitender Miniaturisierung der integrierten Schaltungen wurde es immer schwieriger, die erforderlichen, sehr fein strukturierten Muster von den als Masken bezeichneten Vorlagen auf die mit einer Photolackschicht überzogenen Halbleiterplättchen (Wafer) lichtoptisch zu übertragen. Um die immer feiner strukturierten Masken auf die Halbleiterplättchen zu übertragen, wurden für das sogenannte Projektionsverfahren besonders konstruierte Linsen mit immer höheren Auflösungsvermögen und immer höherer Fehlerfreiheit oder ständig verbesserte und weiterentwickelte, sogenannte Schattenwurfverfahren (Kontakt- oder Proximityprinting) verwendet. Da das extrem hohe Auflösungsvermögen und die erforderliche Fehlerfreiheit selbst bei den besten Linsen schließlich nur im paraxialen Bereich zu finden waren, mußten die auf ein Halbleiterplättchen zu übertragenden Muster durch Hunderte von Einzelbelichtungen schrittweise mittels sogenannter Step-and-repeat-Kameras übertragen werden. Bei den obengenannten Schattenwurfverfahren traten bei sehr fein strukturierten Mustern durch Beugung des Lichtes an den Rändern der Maskenöffnungen Störungen auf, die eine weitere Verkleinerung der integrierten Schaltungen unmöglich machten.

Nachdem die weitere Entwicklung der integrierten Halbleiterschaltungen zu Leiter- und Schaltungselementen mit Durchmessern und Abständen von wesentlich unter 1 µm führt, die maximal erreichbare Auflösungsgrenze aller bekannten optischen Verfahren aber etwa bei 2 µm liegt, ist man zur Belichtung mit Korpuskularstrahlen, insbesondere mit Elektronenstrahlen, übergegangen.

Da die bekannten Korpuskularstrahlenlinsen bei genügend großem Bildfeld nicht das erforderliche Auflösungsvermögen und insbesondere nicht die extrem hohe Verzerrungsfreiheit aufweisen, ist man bei der Verwendung von Korpuskularstrahlen auf das sogenannte Schattenwurfverfahren übergegangen, mit dem Strukturen mit einem Durchmesser von 0,1 µm ohne weiteres mit der für die Herstellung von subminiaturisierten integrierten Halbleiterschaltungen erforderlichen Genauigkeit übertragen werden können.

Bekanntlich sind alle festen Körper für Korpuskularstrahlen praktisch vollständig undurchlässig, so daß für im Zusammenhang mit diesen Strahlen zu verwendende Masken keine durchsichtigen Substrate zur Verfügung stehen. Während bei der Verwendung von im sichtbaren Bereich liegender elektromagnetischer Strahlung die Masken aus einer als durchsichtigen Träger dienenden Glas- oder Quarzplatte bestehen, die mit einer dünnen, beliebig verzweigte und ineinander verschachtelte oder auch ringförmige Ausnehmungen aufweisenden Metallschicht überzogen ist, gibt es bei der Verwendung von Korpuskularstrahlen keine Substanzen, die als durchsichtige Träger oder Substrate dienen könnten. Das hat zur Folge, daß mit Korpuskularstrahlen nur inselförmig isolierte Bereiche übertragen werden können, die darüber hinaus noch so große Abstände aufweisen müssen, daß die Masken noch selbsttragend sind, d. h., die nötige mechanische Starrheit aufweisen. Die Form der durch diese Art von Masken übertragbaren Muster ist daher wesentlichen Beschränkungen unterworfen. Da die bei der Herstellung von integrierten Halbleiterschaltungen zu übertragenden Muster aber ständig nicht nur aus isolierten inselförmigen Bereichen, sondern auch aus ringförmigen oder sehr kompliziert verzweigten und in einander verschachtelten Strukturen bestehen, konnte sich die Belichtung durch Korpuskularstrahlen mittels Schattenwurf trotz des extrem hohen Auflösungsvermögens dieses Verfahrens bei der Herstellung von integrierten Halbleiterschaltungen praktisch nicht durchsetzen.

Wie aus den Literaturstellen »A Solution to the Mask 'Stencil' Problem in Electron Beam Projection Microfabrication« von M. B. Heritage, 7th International Conference on Electron and Ion Beam Science and Technology, Mai 1976, Washington DC, Seiten 348 bis 360, »Transmission Masters for Demagnifying Electron Projection« von A. Meyer et al., ebenda P. 332 bis 339, und »An Electron Image Projector with Automatic Alignment« von J. P. Scott, IEEE Transactions on Electron Devices, Juli 1975, Vol. ED-22, Nr. 7, Seiten 409 bis 413 hervorgeht, wurde schon vorgeschlagen, die bei der Abbildung von ringförmigen Mustern erforderlichen inselförmigen, undurchsichtigen Maskenbereiche mit sehr dünnen, unterhalb des Auflösungsvermögens der verwendeten Abbildungsverfahren liegende Dicken aufweisenden Stegen mit der übrigen Maske zu verbinden. Auch Masken mit mehreren langen, mit geringem Abstand voneinander und zueinander parallel verlaufenden Schlitzen können auf diese Weise hergestellt werden. Das gleiche gilt für Masken, die auf aus sehr dünnen Stäben bestehenden Kreuzgittern angeordnet sind.

Aus der FR-A-2 328 281 ist ein Verfahren zur Belichtung durch Korpuskularstrahlen-Schattenwurf bekannt, bei dem der Korpuskularstrahl um einen angenähert in der Ebene der Maske liegenden Punkt geschwenkt wird, um den Schatten eines Unterstützungsgitters der Maske auszugleichen. Die Ablenkvorrichtung für diese Schwenkung ist als elektrostatische Vorrichtung ausgebildet. Aus der Zeitschrift »Electrochemical Society, Extended Abstracts, Band 74-1, Abstract Nr. 218, Seiten 510 bis 511« ist eine Vorrichtung zur Belichtung mit Korpuskularstrahlen bekannt, bei der das zu belichtende Objekt auf einem in zwei zueinander senkrecht stehenden Richtungen steuerbar verschiebbaren und interferometrisch überwachten Tisch angeordnet ist.

Die obengenannten Verfahren sind aber bei der Herstellung von miniaturisierten integrierten Halbleiterschaltungen nur bei verkleinerndem Projektionsdruck verwendbar, da andernfalls die zu übertragenden Muster durch die Abbildungen der Stege oder der Gitterstäbe gestört werden. Dieses Verfahren ist demnach nicht zur Herstellung hochminiaturisierter, integrierter Halbleiterschaltungen geeignet, da die Herstellung von in stark verkleinertem Maßstab abzubildenden Masken außerordentlich kompliziert und zeitaufwendig ist und darüber hinaus mit diesem Verfahren gleichzeitig jeweils nur relativ kleine Bereiche eines Halbleiterplättchens belichtet werden können, so daß eine nach diesem Verfahren arbeitende Produktion wegen des damit verbundenen hohen zeitlichen Aufwandes und der mit den wiederholten Einzelbelichtungen verbundenen Ausrichtprobleme nicht wirtschaftlich ist. In der ersten der oben erwähnten Literaturstellen wird weiterhin auf ein Verfahren hingewiesen, bei dem die auf einer Glasplatte durch metallisierte Bereiche dargestellten Muster durch Photoelektronenemission auf die zu belichtende Photolackschicht übertragen wird. Da dabei das Halbleiterplättchen Teil der Anode des abbildenden Systems ist, treten insbesondere bei durch vorhergehende Verfahrensschritte gekrümmten oder schon mit Teilen der Schaltung bestückten Halbleiterplättchen Verzerrungen der übertragenen Muster und andere Störungen auf, die einer praktischen Verwendung im Wege stehen. In der gleichen Literaturstelle wird auch auf ein Verfahren hingewiesen, bei dem das zu übertragende Muster in ein Muster transformiert wird, das aus im wesentlichen gleich großen Quadraten besteht. Mit einer solchen Maske wird die Photolackschicht in zwei, vier oder mehr Relativlagen zwischen Maske und Halbleiterplättchen belichtet, wobei die einzelnen, jeweils durch inselförmige Maskenöffnungen bewirkten Teilbelichtungen das gesamte Muster ergeben. Dieses Verfahren ist jedoch auf Muster beschränkt, die sich aus rechtwinkligen Strukturen zusammensetzen. Ferner führt die Mustererzeugung in der Regel zu Mehrfachbelichtungen der das Substrat bedeckenden Photolackschicht, wenn die Linienbreiten keine ganzzahligen, geraden Vielfache der Quadrate sind. Mehrfachbelichtungen können jedoch zu einer Verbreiterung der belichteten Struktur führen. Außerdem ist die Ausrichtung der einzelnen Teilbelichtungen, deren Durchmesser in der Regel jeweils nur Bruchteile des Durchmessers der zu erzeugenden Musterelemente beträgt, so schwierig, daß ein praktischer Einsatz dieses Verfahrens schon bei der Produktion konventioneller integrierter Schaltungen nicht möglich ist. Keines der oben beschriebenen Verfahren ist daher für die Projektion von hochminiaturisierten, integrierten Halbleiterschaltungen geeignet.

Die Erfindung geht von der Aufgabe aus, ein Verfahren anzugeben, durch das die obengenannten Nachteile vermieden werden und mit dem es möglich ist, beliebige Muster mit Durchmessern und Abständen der einzelnen Leiterzüge und Schaltungselemente von 0,1 µm und weniger durch Schattenwurf parallel und gleichzeitig auf relativ große Bereiche von Halbleiterplättchen zu übertragen. Weiterhin soll es möglich sein, diese Muster mit relativ einfachen Vorrichtungen und in relativ kurzen Zeiten mit großer Genauigkeit und weitgehend unabhängig von äußeren Störeinflüssen auf Halbleiterplättchen ohne Beschränkung der Form der Muster und/oder der Größe der gleichzeitig zu belichtenden Felder zu übertragen.

Diese Aufgabe wird durch die in den Ansprüchen 1 und 3 beschriebene Erfindung gelöst, besondere Ausführungsarten der Erfindung sind in den Unteransprüchen gekennzeichnet.

Da beim erfindungsgemäßen Verfahren keine abbildenden Elemente verwendet werden, sind die erforderlichen Apparaturen einfach und die übertragenen Muster frei von Abbildungsfehlern und Verzerrungen. Aus dem gleichen Grunde gibt es praktisch keine Beschränkungen für die Größe der gleichzeitig übertragenen Felder, die zweckmäßigerweise die Größe einer vollständigen Schaltung haben werden. Es ist aber auch möglich, eine größere Anzahl von Schaltungen, beispielsweise die Schaltungen eines ganzen Halbleiterplättchens, gleichzeitig zu übertragen.

Da die Ausrichtung der einzelnen Komplementärmasken in bezug auf die zu belichtenden Halbleiterplättchen durch eine Grobeinstellung durch Verschiebung des Halbleiterplättchens und einer Feinausrichtung durch steuerbare Änderung des Einfallswinkels des Elektronenstrahls auf die Maske erfolgt, können die Einzelbelichtungen in wesentlich schnellerer Reihenfolge als bei den bisher bekannten Verfahren erfolgen. Bedingt durch die Größe der gleichzeitig übertragenen Felder und durch die Kürze der Ausrichtzeiten werden die zur Belichtung eines ganzen Halbleiterplättchens erforderlichen Zeiten um Zehnerpotenzen kürzer als bei den bisher bekannten vergleichbaren Verfahren. Da die Grobeinstellung durch mechanische Verschiebung des Halbleiterplättchens und die Feinausrichtung durch die steuerbare Änderung des Einfallswinkels des Elektronenstrahls unabhängig voneinander erfolgen, genügen für Ausrichtgenauigkeiten von beispielsweise 0,5‰, Ausrichtgenauigkeiten des das Halbleiterplättchen tragenden, verschiebbaren Tisches von 5% und der Ablenkelektronik des Elektronenstrahls von 1%, das sind Werte, die leicht verwirklicht, aber auch noch leicht verbessert werden können.

Ein Weg zur Ausführung der Erfindung wird anschließend an Hand der Figuren näher erläutert. Es zeigen

Fig. 1A bis 1C ein durch eine zum Stande der Technik gehörende Maske zur Korpuskularstrahl-Schattenwurfübertragung zu übertragendes Muster und die Zusammensetzung dieses in Fig. 1A dargestellten Musters durch die in Fig. 1B dargestellte Maske,

Fig. 2 eine Vorrichtung zur Durchführung des erfindungsgemäßen Verfahrens,

Fig. 3A bis 3C ein mit Hilfe des erfindungsgemäßen Verfahrens übertragenes Muster und die zur Übertragung des Musters verwendeten Komplementärmasken.

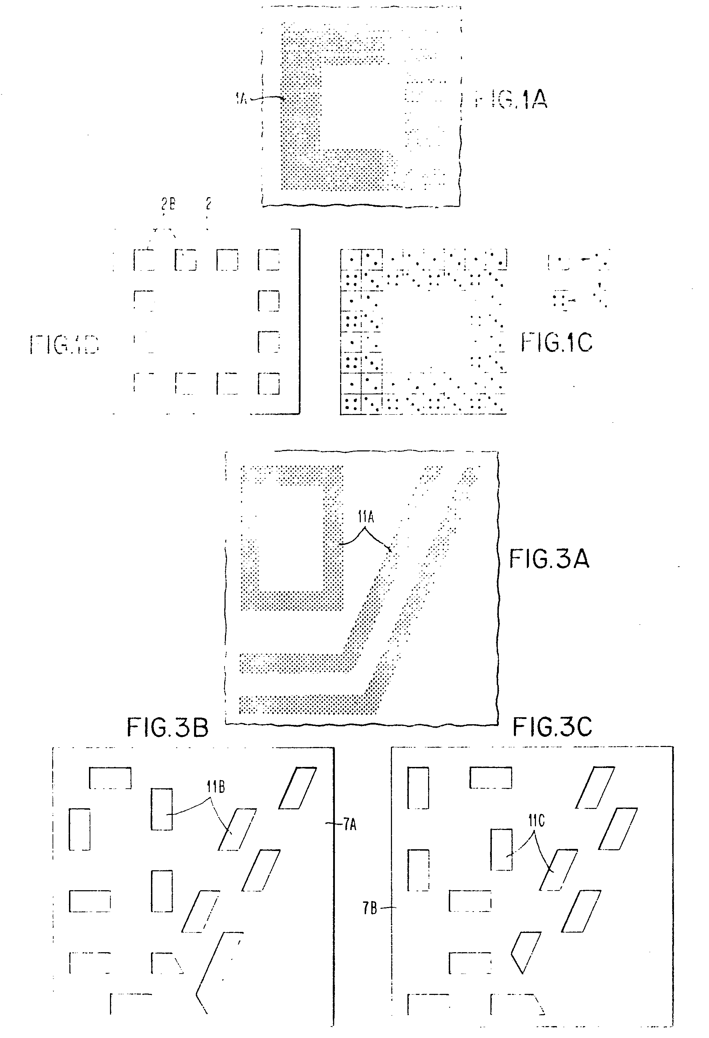

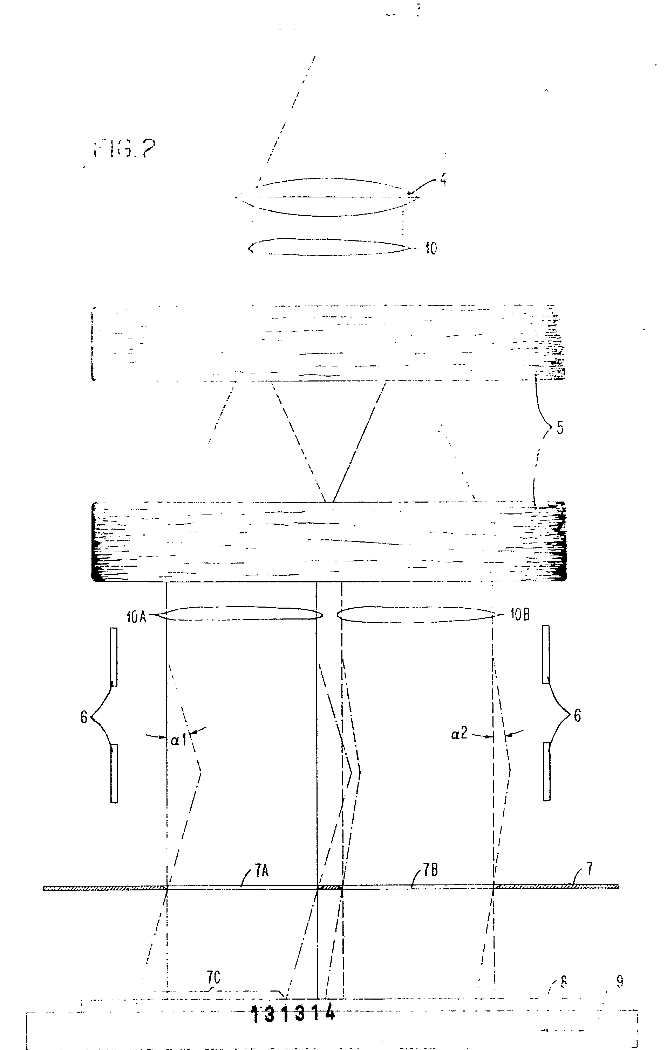

Das in Fig. 1A durch einen gerasterten Bereich 1A dargestellte Muster wird durch die in Fig. 1B dargestellte, aus Öffnungen 2B bestehende Maske 2 übertragen. Dabei wird in an sich bekannter Weise in vier verschiedenen Stellungen der Maske 2 je eine Belichtung durchgeführt. In Fig. 1C sind die Lagen der Maskenöffnungen bei der ersten, zweiten, dritten und vierten Belichtung durch jeweils einen, zwei, drei bzw. vier Punkte enthaltende Quadrate dargestellt. Es ist ohne weiteres einleuchtend, daß die Form der auf diese Weise übertragbaren Muster starken Einschränkungen unterworfen ist und daß das Verfahren insbesondere deshalb sehr umständlich und zeitraubend ist, weil nach jeder Einzelbelichtung eine extrem genaue Ausrichtung erforderlich ist. Aus diesem Grunde konnte sich dieses Verfahren zur Herstellung von integrierten Schaltungen mittels Korpuskularstrahl-Schattenwurfverfahren nicht durchsetzen.

Die in Fig. 2 dargestellte Vorrichtung besteht aus einer Elektronenstrahlkanone 3, einer den von der Elektronenstrahlkanone 3 ausgehenden Strahl in einen Parallelstrahl 10 umwandelnde Elektronenlinse 4, einer magnetischen Ablenkvorrichtung 5 zur Parallelablenkung des Elektronenstrahls 10 in zwei Koordinatenrichtungen, beispielsweise in eine der beiden mit 10A und 10B dargestellten Lagen und aus einer elektrostatischen Ablenkvorrichtung 6, durch die der Elektrostrahl beispielsweise aus den durch 10A oder 10B dargestellten Lagen um einen in der Ebene einer Maske 7 liegenden Drehpunkt steuerbar um auswählbare Winkel geschwenkt werden kann. Ferner ist eine Maske 7 vorgesehen, die aus den nebeneinanderliegenden Komplementärmasken 7A und 7B besteht. Die die Maske durchsetzenden Elektronenstrahlen fallen auf ein mit einer Photolackschicht bedecktes Halbleiterplättchen 8, das auf einem steuerbar in zwei aufeinander senkrecht stehenden Richtungen verschiebbaren Tisch 9 angeordnet ist, dessen Bewegungen interferometrisch überwacht werden.

Die beiden mit 7A und 7B bezeichneten Maskenbereiche enthalten beispielsweise die in den Fig. 3B und 3C dargestellten Durchbrüche 11B und 11C.

Zur Belichtung des in Fig. 3A durch gerasterte Bereiche dargestellten Musters 11A wird der Tisch 9 mit dem darauf befindlichen Halbleiterplättchen 8 in seine in Fig. 2 dargestellte Lage gebracht und die magnetische Ablenkvorrichtung 5 so eingestellt, daß der Weg des Elektronenstrahls in seine mit 10A bezeichnete Lage abgelenkt wird und auf dem durch die ausgezogenen Linien dargestellten Weg auf die Komplementärmaske 7A und in den die Durchbrüche 11B aufweisenden Bereichen auf die das Halbleiterplättchen 8 bedeckende Photolackschicht auftrifft. Wird mittels einer nicht dargestellten Ausrichtvorrichtung und mit Hilfe ebenfalls nicht dargestellter, auf dem Halbleiterplättchen 8 angeordneter Ausrichtmarkierungen festgestellt, daß die Differenz zwischen der Ist-Lage und der Soll-Lage des Halbleiterplättchens von Null verschieden ist, jedoch einen bestimmten Maximalbetrag nicht überschreitet, so wird durch Erregung der elektrostatischen Ablenkvorrichtung 6 der Weg des Elektronenstrahls um einen in der Ebene der Maske 7 liegenden Punkt geschwenkt, so daß er dem durch die strichpunktierten Linien dargestellten Verlauf folgt. Der Ablenkwinkel $\alpha$ 1 wird dabei so eingestellt, daß die durch fehlerhafte Einstellung des Tisches 9 bedingte Abweichung der Ist-Lage von der Soll-Lage kompensiert wird. Anschließend wird der Elektronenstrahl 10 eingeschaltet und die unter dem Maskenbereich 7A liegende Photolackschicht belichtet. Nach Beendigung der Belichtung wird der Tisch 9 so weit nach rechts verschoben, daß der belichtete Bereich 7C des Halbleiterplättchens 8 unter den Komplementärmaskenbereich 7B gelangt. Die magnetische Einstellvorrichtung 5 wird so eingestellt, daß der Weg des Elektronenstrahls 10 in seine durch gestrichelte Linien dargestellte Lage 10B überführt wird. Ergibt eine Überprüfung durch die nicht dargestellte Ausrichtvorrichtung, daß die Ist-Lage des belichteten Bereichs 7C von seiner Soll-Lage abweicht, so wird die elektrostatische Ablenkvorrichtung 6 so eingestellt, daß der Elektronenstrahl um einen in der Ebene der Maske 7 liegenden Punkt um einen Winkel $\alpha$ 2 geschwenkt wird, so daß das Halbleiterplättchen 8 in einem durch die strichpunktierten Linien begrenzten Bereich beaufschlagt wird. Wird in diesem Einstellzustand der Einstellvorrichtungen 5 und 6 die Elektronenstrahlkanone eingeschaltet, so fällt der Elektronenstrahl in seinem durch strichpunktierte Linien dargestellten Verlauf auf einen durch diese Linien begrenzten Bereich des Halbleiterplättchens 8, der bei der durch die Schwenkung des Strahls um den Winkel $\alpha$ 2 herbeigeführten Überein-

stimmung der Ist- und der Soll-Lage genau mit den bereits durch die Maske 7A belichteten Bereich 7C übereinstimmt. Es ist ohne weiteres ersichtlich, daß die Überlagerung der in den Fig. 3B und 3C dargestellten Durchbrüche 11B und 11C das in Fig. 3A wiedergegebene Muster 11A erzeugt. Die Ablenkung des Elektronenstrahls 10 in seine mit 10A und 10B dargestellten Lagen mittels der magnetischen Ablenkvorrichtung 5 sowie die eine Schwenkung um einen in der Ebene der Maske 7 liegenden Punkt bewirkende Ablenkung um einen einstellbaren Winkel $\alpha$ durch die elektrostatische Ablenkvorrichtung 6 kann selbstverständlich nicht nur in der Ebene der Zeichnung, sondern in allen Richtungen erfolgen, so daß in beliebigen Richtungen auftretende Positionierungsfehler kompensiert werden können.

Übersteigt die Differenz zwischen der Soll-Lage und der Ist-Lage des Plättchens 8 den oben erwähnten, maximal zulässigen Wert, so erfolgt eine neue Grobeinstellung durch eine Verschiebung des Tisches 9, dem eine neue Feineinstellung durch Veränderung der Winkel $\alpha$ durch die elektrostatische Ablenkvorrichtung 6 folgt.

Wie schon eingangs erwähnt, werden an die Genauigkeit der programmierten und interferometrisch überwachten Verschiebungen des Tisches 9 keine sehr hohen Anforderungen gestellt, so daß diese mit großer Geschwindigkeit erfolgen können. Dieser interferometrisch überwachten Grobeinstellung folgt eine mit extremer Genauigkeit und extrem hoher Geschwindigkeit durchgeführte Feineinstellung durch Schwenkung des Elektronenstrahls 10 um beliebige Winkel $\alpha$ um einen in oder annähernd in der Ebene der Maske 7 liegenden Punkt, die durch Einstellung der elektrostatischen Ablenkvorrichtung 6 erfolgt. Die Verschiebung des Tisches 9, die Auswertung und Korrektur der interferometrisch festgestellten Soll-Wertabweichungen, die Betätigung der Ablenkvorrichtungen 5 und 6 sowie das Ein- und Ausschalten der Elektronenstrahlkanone 3 kann in besonders vorteilhafter Weise durch einen programmierten Computer erfolgen. Das erfindungsgemäße Verfahren kann aber selbstverständlich auch mit weniger technischem Aufwand halbautomatisch durchgeführt werden.

**Patentansprüche**

1. Verfahren zur Belichtung eines Objekts durch Korpuskularstrahlen, bei dem ein auf das Objekt zu übertragendes Muster durch Überlagerung zweier nacheinander belichteter Teilmuster erzeugt wird, dadurch gekennzeichnet, daß für eine Schattenwurfprojektion mit während der Belichtungszeit ortsfestem Korpuskularstrahl die Fläche des herzustellenden Musters (11A) in komplementäre, ganz von unbelichteten Bereichen umschlossene insel-förmige Einzelbereiche (11B, 11C) zerlegt wird, die die Öffnungsmuster zweier nebeneinanderliegender Komplementärmasken (7A, 7B) festlegen, die in einem Abstand von etwa 100 μm bis 2000 μm parallel zu dem zu belichteten Objekt (8) und in Strahlrichtung vor diesem angeordnet werden, daß in einer ersten Teilbelichtung die erste Komplementärmaske (7A) mit dem Korpuskularstrahl (10A) beaufschlagt wird, daß nach der ersten Teilbelichtung der belichtete Flächenbereich (7C) des Objekts (8) derart unter den zweiten Komplementärbereich (7B) der Maske geschoben wird, daß die Überlagerung der belichteten Flächen des Objekts mit den Öffnungen der zweiten Komplementärmaske (7B) bei deren Bestrahlung mit dem parallel zu sich selbst verschobenen Korpuskularstrahl (10B) das auf dem Objekt herzustellende Muster ergibt und daß vor jeder Teilbelichtung die Abweichung der Ist-Lage des Objekts von seiner Soll-Lage festgestellt wird und der Ausrichtfehler durch Schwenkung des Korpuskularstrahls um einen annähernd in der Ebene der Maske (7) liegenden Punkt kompensiert wird.

2. Verfahren nach Anspruch 1, dadurch gekennzeichnet, daß die Kompensation des festgestellten Ausrichtfehlers bei Überschreiten einer vorgegebenen Soll-Ist-Abweichung zunächst durch eine Bewegung des das Objekt tragenden Tisches (8) und dann durch die Schwenkung des Elektronenstrahls (10) um einen angenähert in der Ebene der Maske (7) liegenden Punkt erfolgt.

3. Vorrichtung zur Belichtung durch Korpuskularstrahl-Schattenwurf, insbesondere zur Durchführung des Verfahrens nach Anspruch 1 oder 2, gekennzeichnet durch eine erste Ablenkvorrichtung (5) zur steuerbaren Parallelablenkung eines Korpuskularstrahls (10), durch eine zweite Ablenkvorrichtung (6) zur steuerbaren Schwenkung des Korpuskularstrahls um einen angenähert in der Ebene einer zu übertragenden Maske liegenden Punkt, durch Mittel zur Feststellung von Ausrichtfehlern und Vorrichtungen zur Steuerung der zweiten Ablenkvorrichtung zur Schwenkung des Korpuskularstrahls um einen die ermittelten Ausrichtfehler kompensierenden Winkel $\alpha$.

4. Vorrichtung nach Anspruch 3, dadurch gekennzeichnet, daß das zu belichtende Objekt (8) auf einem in zwei zueinander senkrecht stehenden Richtungen steuerbar verschiebbaren und interferometrisch überwachten Tisch (9) angeordnet ist.

5. Vorrichtung nach den Ansprüchen 3 und 4, dadurch gekennzeichnet, daß die Ablenkvorrichtung (5) zur Parallelverschiebung des Korpuskularstrahls als elektromagnetische Vorrichtung ausgebildet ist.

6. Vorrichtung nach den Ansprüchen 3 und 4, dadurch gekennzeichnet, daß die Ablenkvorrichtung (6) zur Schwenkung des Korpuskularstrahls um einen angenähert in der Maskenebene liegenden Punkt als elektrostatische Vorrichtung ausgebildet ist.

## Claims

1. Method of exposing an object through corpuscular beams, where a pattern to be transferred onto the object is produced through the superposition of two successively exposed partial patterns, characterized in that for a shadow printing projection with a corpuscular beam that is stationary during the exposure period, the surface of the pattern (11A) to be made is divided into complementary island shaped individual areas (11B, 11C) completely surrounded by inexposed areas, said individual areas determining the aperture patterns of two adjacent complementary masks (7A, 7B) arranged at a distance of approximately 100 μm to 2000 μm in parallel to the object (8) to be exposed, and preceding it in beam direction, that in a first partial exposure the first complementary mask (7A) is applied with the corpuscular beam (10A), that after the first partial exposure the exposed surface area (7C) of the object (8) is placed under the second complementary area (7B) of the mask in such a manner that the superposition of the exposed object areas onto the apertures of the second complementary mask (7B) upon its irradiation with the corpuscular beam (10B) shifted in parallel to itself provides the pattern to be made on the object, and that prior to each partial exposure the deviation of the actual position of the object from its nominal position is determined, and that the alignment error is compensated by tilting the corpuscular beam about a point approximately in the plane of the mask (7).

2. Method as claimed in claim 1, characterized in that if a predetermined nominal-actual deviation is exceeded the alignment error found is compensated first, by moving the table (8) carrying the object, and subsequently by tilting the electron beam (10) about a point approximately in the plane of the mask.

3. Method of exposure through corpuscular beam shadow printing, particularly for carrying out the method as claimed in claim 1 or 2, characterized by a first deflection unit (5) for the controllable parallel deflection of the corpuscular beam (10), by a second deflection unit (6) for the controllable tilting of the corpuscular beam about a point approximately in the mask plane, by means for determining alignment errors and control devices for tilting the corpuscular beam about an angle α compensating the alignment errors found.

4. Device as claimed in claim 3, characterized in that the object (8) to be exposed is arranged on a table (9) that is controllably shiftable in two directions perpendicular to each other, and interferometrically controlled.

5. Device as claimed in claims 3 and 4, characterized in that the deflection unit (5) is designed as an electromagnetic unit for the parallel shifting of the corpuscular beam.

6. Device as claimed in claims 3 and 4, characterized in that the deflection unit (6) is designed as an electrostatic unit for tilting the corpuscular beam about a point approximately in the mask plane.

## Revendications

1. Procédé pour exposer un objet à l'aide de rayons corpusculaires, dans lequel une configuration qui est à reporter sur l'objet est obtenue par superposition de deux configurations partielles exposées l'une après l'autre, caractérisé en ce que, pour une projection d'ombre par un faisceau corpusculaire qui est stationnaire pendant la durée d'exposition, l'on décompose la surface de la configuration à produire (11A) en régions individuelles complémentaires en forme d'îlots (11B, 11C), entièrement entourés par des régions non exposées, ces régions individuelles déterminant les configurations d'ouvertures de deux masques complémentaires adjacents (7A, 7B) disposés dans la direction du rayon, devant l'objet à exposer (8), parallèles avec celui-ci et à une distance d'environ 100 μm à 2000 μm, en ce que l'on applique, durant une première exposition partielle, le premier masque complémentaire (7A) avec un faisceau corpusculaire (10A), en ce que l'on déplace, après la première exposition partielle, la surface de régions exposées (7C) de l'objet (8) sous la seconde région complémentaire (7B) du masque de sorte que la superposition des surfaces exposées de l'objet avec les ouvertures du second masque complémentaire (7B) par leur irradiation à l'aide du faisceau corpusculaire (10B) déplacé en parallèle par rapport à lui-même donne la configuration à produire sur l'objet, et en ce que l'on détermine, avant chaque exposition partielle, la déviation de la position effective de l'objet à partir de sa position nominale, et que l'on compense l'erreur d'alignement en tournant le faisceau corpusculaire autour d'un point situé approximativement dans le plan du masque (7).

2. Procédé selon la revendication 1, caractérisé en ce que, l'on compense l'erreur d'alignement déterminée due au dépassement d'une déviation prédéterminée effective-nominale d'abord par un mouvement de la table (8) portant l'objet et ensuite par la rotation du faisceau électronique (10) autour d'un point situé approximativement dans le plan du masque (7).

3. Dispositif pour exposition par projection d'ombre à l'aide du faisceau corpusculaire, en particulier pour appliquer le procédé selon la revendication 1 ou 2, caractérisé en ce qu'il comporte un premier élément de déflexion (5) pour contrôler la déviation parallèle d'un faisceau corpusculaire (10), un second élément de déflexion (6) pour contrôler la rotation du faisceau corpusculaire autour d'un point situé approximativement dans le plan d'un masque à transférer, des moyens pour déterminer les erreurs d'alignement, et des dispositifs de contrôle du second élément de déflexion pour tourner le faisceau corpusculaire autour d'un

angle $\alpha$ qui compense les erreurs d'alignement déterminées.

4. Dispositif selon la revendication 3, caractérisé en ce que l'objet (8) à exposer est disposé sur une table (9) qui peut être déplacée et contrôlée par interférométrie dans deux directions perpendiculaires l'une par rapport à l'autre.

5. Dispositif selon l'une quelconque des revendications 3 et 4, caractérisé en ce que l'élément de déflexion (5) constitue un dispositif électromagnétique pour le déplacement parallèle du faisceau corpusculaire.

6. Dispositif selon l'une quelconque des revendications 3 et 4, caractérisé en ce que le dispositif de déflexion (6) constitue un dispositif électrostatique pour la rotation du faisceau corpusculaire autour d'un point situé approximativement dans le plan du masque.

FIG.1A

FIG.1B

FIG.1C

FIG.3A

11A

FIG.3B

11B

7A

FIG.3C

11C

7B

FIG.2